(19) Europäisches Patentamt
European Patent Office
Office européen des brevets

(11) **EP 2 107 139 B1**

(12) **EUROPEAN PATENT SPECIFICATION**

(45) Date of publication and mention of the grant of the patent:
**21.06.2017   Bulletin 2017/25**

(21) Application number: **06849646.2**

(22) Date of filing: **19.12.2006**

(51) Int Cl.:
*C30B 30/00* (2006.01)    *C22B 9/02* (2006.01)
*B01D 9/00* (2006.01)    *C30B 11/00* (2006.01)
*C30B 29/02* (2006.01)

(86) International application number:
**PCT/RU2006/000678**

(87) International publication number:
**WO 2008/075994 (26.06.2008 Gazette 2008/26)**

(54) **METHOD FOR PRODUCING SUPERPURITY METALS AND MONOCRYSTALS MADE THEREFROM**

VERFAHREN ZUR HERSTELLUNG VON SUPERREINEN METALLEN UND DARAUS HERGESTELLTE EINKRISTALLE

PROCÉDÉ DE FABRICATION DE MÉTAUX TRÈS PURS ET DE MONOCRISTAUX SUR LEUR BASE

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(43) Date of publication of application:
**07.10.2009   Bulletin 2009/41**

(73) Proprietor: **Advanced Alloys GmbH**
**12435 Berlin (DE)**

(72) Inventors:
• **POPOV, Anatoliy Vladimirovich**
**Samara 443082 (RU)**

• **SKALDIN, Nikolai Nikolaevich**
**Moscow 117393 (RU)**
• **TKACHEV, Sergei Semenovich**
**Omsk 644088 (RU)**

(74) Representative: **Einsel, Martin**
**Patentanwälte Einsel & Kollegen**
**Jasperallee 1a**
**38102 Braunschweig (DE)**

(56) References cited:
**EP-B1- 1 252 375      JP-A- 07 054 063**
**JP-A- 11 172 345      JP-A- 11 172 345**
**RU-C2- 2 191 211      US-A1- 2006 137 599**

**Description**

FIELD OF THE INVENTION

The invention relates to metallurgy and foundry engineering.

DESCRIPTION OF THE PRIOR ART

At present, superpure metals are produced by zone refining only.

Refining of this type is based on a physical phenomenon in which impurities are pushed into the melt by the growing crystal, that is, by the solidification front of a solid having a poly- or monocrystalline structure.

The different alternatives of zone melt refining known in prior art (Pfann, W.G., Zone Melting, Wiley, N.Y., 1958; and Chalmers, B., Principles of Solidification, 1968, p. 144) are based on multiple repetitions of the local melting cycle, the local zone moving three-dimensionally and organizing synchronous movement of the solidification front. Moreover, viewed in cross-section, the solidification front has an unmistakably parabolic shape.

Besides, the solidification front is not flat at the micro level because of the alternative dendrite front that affects significantly the "refining" properties of the solidification front. A dendritic or, in the best case, cellular solidification front retains, to an extent, the impurities, or adsorbents, at times localizing them into periodically distributed three-dimensional structures. In these situations, five to seven refining cycles are required to remove, for example, impurities of the 9x10% order.

Methods for producing monostructures that are known in prior are all based, without an exception, on overcooling fields corresponding (approximately) to the maximum linear speed of crystal growth (Csochralski, J.Z., Physik. Chem. 1917, Bd 92, S. 219; and Chalmers B. Principles of Solidification, 1968, p. 280).

The prior art method has been accepted as immediate prior art of this invention.

To obtain a desired crystallographic orientation, however, seed crystals arranged in an appropriate position are required to be used.

This prior art method is disadvantageous because it does not allow physically to combine refining and growth of monostructures in a single metal making process. Moreover, it is physically impossible to raise significantly the zone refining output and growth speed of monostructures.

DESCRIPTION OF THE INVENTION

This invention is basically aimed at developing a method for producing superpure metals and monocrystals from them that combines effective refining of melts of any metals and growth of mono- or quasi-monocrystalline structures of metals or alloys thereof, wherein the melt is solidified during three-dimensional cooling.

The technical result of this invention consists in improving the efficiency of production of superpure metals and monocrystals from them by maintaining completely flat solidification fronts and applying a high gravitation, which results in a steep decrease of the two-phase zone and a sharp contraction of the growth metastability range and optimal overcooling value corresponding to the maximum linear speed of monocrystal growth.

This technical result is achieved by a method for producing superpure metals and monocrystals from them, comprising creating overcooling fields in the melt exceeding the growth metastability range; solidifying the melt to obtain a monocrystalline structure and desired refining within the field of force of centrifuges at a gravitation factor capable of producing overcooling in the melt equal to the difference between the optimal overcooling value corresponding to the maximum linear crystal growth speed within the growth metastability range, which is found from the formula:

$$\Delta T = \sqrt{\frac{A}{T \ln \Theta}},$$

wherein $\Theta$ is correction to the gravitation factor

$$\Theta = \frac{10^{23}}{B\,K_g + 10^{23}\,\exp\left\{-\dfrac{A(1 \cdot L\,K_g)^3}{T(\Delta T_0 + M\,K_g)^3}\right\}}$$

A, B, L, and M are technical parameters (coefficients), the numerical value of B being found from the thermodynamic characteristics of the mold that determine the rate of thermal processes, and the numerical values of A, L, and M depending on the physical and chemical characteristics of the metals;
Kg is the gravitation factor;
T is the solidification temperature; and
$\Delta T_0$ are metal overcooling values computed experimentally.

Moreover, as monocrystals are grown and the melt is refined the melt is cooled volumetrically at a rate of 0.02 to 0.08°C/sec.

These are significant features interrelated in a stable combination of essential features sufficient for producing the above technical result.

The claimed method is based on the use of an essentially new physical phenomenon to control the growth of mono- or quasi-monocrystalline structures from any melts by exposing them to oriented external fields of force and simultaneously refining them.

The suitability of any method for growing monostructures from melt can best, in our opinion, be analyzed with the aid of Tamman dependences. These dependences show how the nuclei formation rate $n(\Delta T)$ and the linear crystal growth speed $V(\Delta T)$ change with variations of the fields of force originating in the melt $(\Delta T)$. These dependences are convex functions and have extreme values at overcooling values $\Delta T_{opt}^{n}$ and $\Delta T_{opt}^{v}$.

These inventors have demonstrated theoretically and experimentally that the effect of, for example, gravitational fields on a solidifying melt is similar to the creation of overcooling fields in the melt. It follows, therefore, that there is a deterministic dependence between the value of $\Delta T$ and the gravitation factor Kg.

Since Kg is an easily controlled parameter and has an identical effect on any sections of the melt, a conclusion can be drawn that any method in which $\Delta T$ is replaced with Kg possesses high potentialities for growing monostructures.

DESCRIPTION OF THE DRAWINGS AND PRINCIPLE OF THE INVENTION

The present invention will be more apparent from the following drawings in which:

FIG. 1 is a diagrammatic view of normalized Tamman dependences; and
FIG. 2 illustrates the dependence of relative overcooling on the gravitation factor Kg.

In accordance with this invention, the claimed method for producing superpure metals and monocrystals from them is to be carried out in a revolving mold in the following conditions:

- to produce a monocrystalline structure and simultaneously carry out refining, the melt is solidified in the field of force of centrifuges at a gravitation factor allowing overcooling fields to be created in the melt and equal to the difference between the optimal overcooling value corresponding to the maximum linear crystal growth speed within the growth metastability range found from the following formula:

$$\Delta T = \sqrt{\frac{A}{T \ln \Theta}} \qquad (1)$$

wherein:

$$\Theta = \frac{10^{23}}{B\,K_g + 10^{23}\,\exp\{-\dfrac{A(1 - L\,K_g)^3}{T(\Delta T_0 + M\,K_g)^2}\}} \qquad (2)$$

A, B, L, and M are technical parameters (coefficients) that are used to compute the numerical value of B on the basis of the thermodynamic characteristics of the mold that determine the rate of the thermal process, and the numerical values of A, L, and M are determined by the physical and chemical characteristics of the metals;
Kg is the gravitation factor;
T is the solidification temperature;

$\Delta$To are melt overcooling values computed experimentally;

- when monocrystals are grown and the melt is refined, the melt is cooled volumetrically at a rate of 0.02 to 0.08°C/sec.

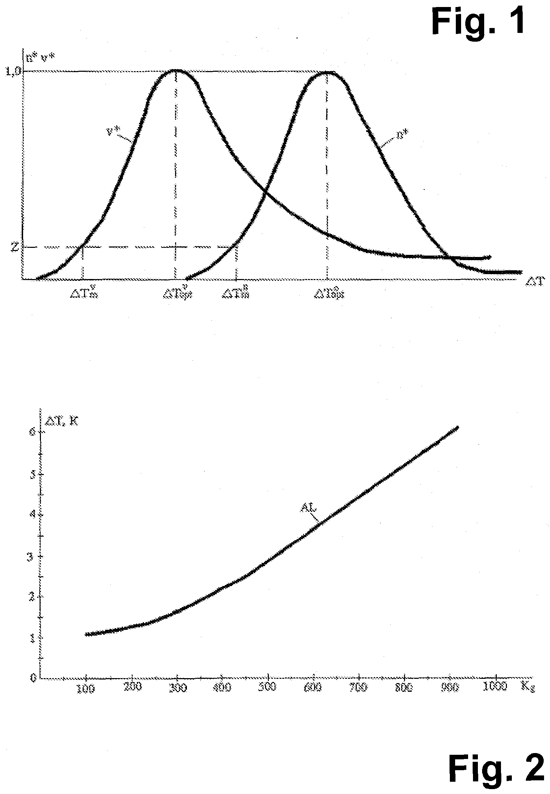

The Tamman curves are examined below to explain the idea of the claimed method with reference to FIG. 1.

The first curve V($\Delta$T) describes change in the linear crystal growth speed depending on overcooling values $\Delta$T produced in the melt.

The second curve n($\Delta$T) describes change in the nucleation rate depending on $\Delta$T.

The different level Z of both dependences is matched by overcooling values $\Delta T_m^V$ and $\Delta T_m^n$, termed growth metastability and nucleation ranges.

The optimal overcooling values $\Delta T_{opt}^v$ and $\Delta T_{opt}^n$ are the coordinates of the maximum values.

It is natural to assume that maximum efficiency is achieved by a method for producing monostructures that creates overcooling fields equal to $\Delta T_{opt}^v$ in the melt during growth. This objective cannot, in principle, by attained with the aid of nonuniform thermal fields produced by any method because of latent solidification heat liberation, uninterrupted change in the thermal resistance of the growing monocrystal, and because it is impossible to know the solidification front coordinates exactly.

Accordingly, the inventors measured, in the course of analytical and experimental studies, the deterministic dependence of $\Delta$T on Kg:

$$\triangle \mathrm{T} = \sqrt{\frac{A}{T \ln \Theta}} \qquad (1)$$

wherein:

$$\Theta = \frac{10^{23}}{B \, K_g + 10^{23} \, \exp\{-\frac{A(1-L \, K_g)^3}{T(\triangle T_0 + M \, K_g)^2}\}} \qquad (2)$$

A, B, L, and M are technical parameters (coefficients), the numerical value of B being determined from the thermodynamic characteristics of the mold that affect the rate of thermal processes, and the numerical values of A, L, and M being determined by the physical and chemical characteristics of the metals;

Kg is the gravitation factor;

T is the solidification temperature; and

$\Delta$To are melt overcooling values computed experimentally.

The technical parameters or factors A, L, and M for different metals have the following numerical values:

|   | Aluminum | Copper | Nickel |
|---|---|---|---|
| A | 81 x 10 | 192 x 10 | 644 x 10 |
| L | 2.997 x 10 | 9.879 x 10 | 9.879 x 10 |
| M | 2.997 x 10 | 9.879 x 10 | 9.879 x 10 |

Computation of the last formulas is omitted.

With reference to formula (1), the $\Delta$T coordinate in the Tamman dependences may be replaced with Kg (FIG. 1). It follows then that once the values of Kg are equal to Kopt, a mono- or quasi-monocrystalline structure would be grown from the melt with an arbitrary number of nuclei and clusters at a theoretically possible speed. In particular, the inventors grew a gallium arsenide monocrystal in several experiments at a speed of 10 to 15 cm/sec.

In geometric terms, dependence (1) is a rising hyperbola for all metals, with Kg increasing as well.

This may be illustrated (FIG. 2) by two diagrams built by computation and showing dependence of relative overcooling on Kg for different values of $\Delta$To. The curves were computed from the formula:

$$\mu = \frac{\Delta T}{\Delta T_{0.5}} \qquad (3)$$

wherein: $\Delta T$ is described by formula (1); and

$\Delta T_{0.5}$ is natural overcooling value of the melt equal to 0.5C°.

The diagrams show that regardless of initial overcooling, the maximum effect of this method is achieved at Kg = 300.

The following point is to be made.

Experimental studies of solidifying models of salol-type metals show that the derivative $\delta V(\Delta T)/\delta T$ cannot be less than $10 \cdot 10^2$. As will be shown below, this fact is extremely important.

A melt in a centrifuge at a specified value of $K_g = K_{opt}^v - K_{\mu}^v$ is assumed to cool slowly until a natural overcooling $\Delta To = \Delta T\mu$ is reached, that is, conditions sufficient for linear growth of a crystal from any substrate are created in the melt.

Since the gravitation factor $K_g = K_{opt}^v - K_{\mu}^v$ is adequate to overcooling $\Delta T_g = \Delta T_{opt}^v - T_{\mu}^v$, it is possible to establish the extent to which the linear growth speed of a monocrystal increases in these conditions:

$$\Delta V = \Delta T \times \frac{\delta V(\Delta T)}{d\Delta T} = (\Delta T_{opt}^v - \Delta T_{\mu}^v)10 \qquad (4)$$

Even allowing that adequate overcooling of 1°C is produced in the centrifuge by a nonuniform field of force, it is obvious from (4) that the linear growth speed of the monocrystal increases absolutely by $\Delta V \approx 10$ mm/sec.

Using the above physical mechanism in which a field of force influences a solidifying melt, it is possible to grow monocrystals at extremely high speeds. Moreover, this method is advantageous for three reasons:

First, the gravitation factor is identical at any points of the melt equidistant from the axis of revolution, producing very flat solidification fronts.

Second, the effect of high gravitation causes a rapid contraction of the two-phase zone and, therefore, allows the melt to be purified (refined) more effectively.

Third, high gravitation results in a sharp decrease in the growth metastability range $\Delta T_{\mu}^v$ and the optimal overcooling value $\Delta T_{opt}^v$ corresponding to the maximum value of linear growth speed of monocrystals.

The above factors that have been computed analytically and confirmed experimentally give grounds for arguments that this method is, on average 5 to 20 times as effective as any other methods for refining and growing monocrystals.

The experimental studies of this method included growing monocrystals from aluminum, copper, gallium arsenide, and refractory nickel alloys with a nickel content of up to 72%. Monocrystals were grown in the form of cylinders up to 180 mm long and up to 100 mm in diameter. The minimum (registered) growth speed of a monostructure of, for example, aluminum was between 0.2 and 0.3 mm/sec. Minimum refining efficiency of aluminum was registered when the feedstock had a purity of 99.995%, yielding 99.9991% pure aluminum. Maximum efficiency was registered when 99.99997% pure aluminum was produced from 99.995% pure feedstock per one refining cycle.

The present invention may be used for producing any monocrystals or ingots of mono- or quasi-mono crystalline structure.

It is also expedient to use this invention for effectively refining any metals and their melts.

This invention is applicable on an industrial scale because, with reference to prior art methods for producing superpure metals and monocrystals, technical result is achieved by exposing a melt to the field of force of a centrifuge at a specified gravitation factor.

## Claims

1. A method for producing superpure metals and monocrystals from them, comprising creating in the melt an overcooling field exceeding the growth instability range, wherein a monocrystalline structure is produced and refining is conducted simultaneously by solidifying the melt in the field of force of centrifuges at a gravitation factor allowing overcooling to be produced in the melt that is equal to the difference between the optimal overcooling value corresponding to the maximum linear growth speed of the crystal and the growth metastability range, said difference being determined from the formula:

$$\Delta T = \sqrt{\frac{A}{T \ln \Theta}},$$

wherein:

$$\Theta = \frac{10^{23}}{B K_g + 10^{23} \exp\{-\frac{A(1 - L K_g)^3}{T(\Delta T_0 + M K_g)^2}\}}$$

$\Theta$ is a gravitation factor correction;

A, B, L, and M are coefficients, the value of B being determined on the basis of the thermodynamic characteristics of the mold that determine the rate of thermal process, and the numerical values of A, L, and M being determined by the physical and chemical characteristics of metals;

Kg is the gravitation factor;

T is the solidification temperature; and

$\Delta T_0$ are melt overcooling values obtained experimentally.

2. The method as claimed in claim 1, wherein monocrystals are grown and the melt is refined by volumetrically cooling the melt at a rate of 0.02 to 0.08°C/sec.

## Patentansprüche

1. Verfahren zur Herstellung von superreinen Metallen und Einkristallen daraus, umfassend Erzeugen eines unterkühlten Feldes in der Schmelze, das den Bereich der Wachstumsinstabilität übersteigt, wobei eine einkristalline Struktur hergestellt und gleichzeitig raffiniert wird, indem die Schmelze in einem Kraftfeld von Zentrifugen bei einem Gravitationsfaktor verfestigt wird, der die Ausbildung einer Unterkühlung in der Schmelze ermöglicht, der der Differenz zwischen dem optimalen Unterkühlungswert, der der maximalen linearen Wachstumsgeschwindigkeit des Kristalls entspricht, und des Wachstumsmetastabilitätsbereichs gleich ist, wobei die Differenz mit folgender Formel bestimmt wird:

$$\Delta T = \sqrt{\frac{A}{T \ln \Theta}},$$

wobei:

$$\Theta = \frac{10^{23}}{B K_g + 10^{23} \exp\{-\frac{A(1 - L K_g)^3}{T(\Delta T_0 + M K_g)^2}\}}$$

$\Theta$ ist eine Korrektur des Gravitationsfaktors;

A, B, L, und M sind Koeffizienten, wobei der Wert von B auf Basis der thermodynamischen Charakteristiken der Schmelze bestimmt wird, die die Geschwindigkeit des thermischen Prozesses bestimmen, und die numerischen Werte von A, L und M durch die physikalischen und chemischen Eigenschaften des Metalls bestimmt werden;

Kg ist der Gravitationsfaktor;

T ist die Verfestigungstemperatur; und

ΔTo Unterkühlungswerte der Schmelze sind, die experimentell erhalten worden sind.

2. Verfahren nach Anspruch 1, wobei Einkristalle wachsen und die Schmelze durch volumetrisches Kühlen der Schmelze mit einer Geschwindigkeit von 0,02 bis 0,08 °C/sec. raffiniert wird.

**Revendications**

1. Procédé de production de métaux extra-purs et de monocristaux à partir de ceux-ci, comprenant la création dans la masse fondue d'un champ de surrefroidissement dépassant la plage d'instabilité de croissance, dans lequel une structure monocristalline est produite et le raffinage est réalisé simultanément par la solidification de la masse fondue dans le champ de force de centrifugeuses à un facteur de gravitation permettant à un surrefroidissement d'être produit dans la masse fondue qui est égal à la différence entre la valeur optimale de surrefroidissement correspondant à la vitesse maximale de croissance linéaire du cristal et la plage de métastabilité de la croissance, ladite différence étant déterminée à partir de la formule :

$$\Delta T = \sqrt{\frac{A}{T \ln \Theta}},$$

dans laquelle

$$\Theta = \frac{10^{23}}{B K_g + 10^{23} \exp\{-\frac{A(1-L K_g)^3}{T(\Delta T_0 + M K_g)^2}\}}$$

Θ est une correction du facteur de gravitation ;

A, B, L et M sont des coefficients, la valeur de B étant déterminée sur la base des caractéristiques thermodynamiques du moule qui déterminent la vitesse du processus thermique, et les valeurs numériques de A, L et M étant déterminées par les caractéristiques physiques et chimiques des métaux ;

Kg est le facteur de gravitation ;

T est la température de solidification ; et

ΔTo sont les valeurs de surrefroidissement de masse fondue obtenues expérimentalement.

2. Procédé selon la revendication 1, dans lequel des monocristaux sont formés et la masse fondue est raffinée par le refroidissement volumétrique de la masse fondue à une vitesse de 0,02 à 0,08 °C/seconde.

# Fig. 1

# Fig. 2

## REFERENCES CITED IN THE DESCRIPTION

**Non-patent literature cited in the description**

- **PFANN, W.G.** Zone Melting. Wiley, 1958
- **CHALMERS, B.** *Principles of Solidification,* 1968, 144
- **CSOCHRALSKI, J.Z.** *Physik. Chem.,* 1917, vol. 92, 219
- **CHALMERS B.** *Principles of Solidification,* 1968, 280